# EUROPEAN PATENT APPLICATION

(11) **EP 2 924 881 A1**
(43) Date of publication of application: **30.09.2015**
(21) Application number: 15160265.3
(22) Date of filing: 23.03.2015
(51) Int. Cl.: H03M 5/16, H03M 5/12, H03M 5/20

(54) **Improvements in or relating to signal processing**

(30) Priority: 26.03.2014 EP 14161804
(71) Applicant: IMEC VZW, 3001 Leuven (BE); Universiteit Gent, 9000 Gent (BE)
(72) Inventor: De Keulenaer, Timothy, B-3001 Leuven (BE); Vaernewyck, Renato, B-3001 Leuven (BE); Bauwelinck, Johan, B-3001 Leuven (BE); Torfs, Guy, B-3001 Leuven (BE)
(74) Representative: Gevers Patents

(57) **Abstract**

Described herein is a multi-level to binary converter in which a cascade of differential limiting amplifiers are utilised for each signal path to provide both increased gain and increased bandwidth without having to trade one off against the other. Where the multi-level data is duobinary, cascaded amplifiers (305, 315, 320, 330) are coupled to a XOR logic gate (140). In each path, a copy of the duobinary signal is level shifted using an adjustable threshold before amplification in an amplifier (305, 315). The shifted and amplified signal is then fed to another amplifier (320, 330) where it undergoes the same steps. The outputs from each path are fed to the XOR logic gate (140) to generate the desired binary signal, corresponding to a decoded synchronized NRZ data stream. Such a multi-level to binary converter is capable of performing at data rates of 50 to 80 Gb/s and above, and can easily be integrated within a chip for high-speed electrical backplane communication, optical backplanes or optical fibre links.

## Description

### Field of the disclosure

The disclosure relates to improvements in or relating to signal processing, and, in particular, to the transmission of high speed data through electrical backplanes.

### Background of the disclosure

Today's research strongly focuses in high-speed (multi-level) optical and electrical interconnects with particular focus on interconnects using partial response and multi-level modulation formats. A multi-level signal is a signal having a period T and comprising n signal levels, n being equal to or greater than 3. Examples of multi-level signals include duobinary, polybinary, PAM-4, PAM-8 signals etc. A duobinary signal is a three-level signal whose waveform comprises two eyes, a PAM-4 signal is a four-level signal whose waveform comprises three eyes. The number of the signal levels of a pulse amplitude modulated (PAM) signal corresponds to the number of the discrete pulse amplitudes (usually some power of two). For example, in a PAM-4 signal, there are 2² possible discrete pulse amplitudes and in a PAM-8 signal, there are 2³ possible discrete pulse amplitudes. The reception of such a multi-level modulation signal involves decoding the signal value from a multi-level received signal. This may be realized by an analog to digital converter (ADC) which directly decodes the signal level into bit values. However, circuit implementations of a high-speed ADC are characterized by high power consumption and limited analog bandwidth. To achieve very high transmission rates (for example, beyond 40Gb/s) in the decoder, electrical duobinary signaling has been proposed.

Duobinary signaling has first been described by Lender in "The duobinary technique for high-speed data transmission, "Transactions of the American Institute of Electrical Engineers, Part I: Communication and Electronics, vol.82, no.2, pp.214,218, May 1963. It consists in transmitting N Gb/s using less than N/2 Hz of bandwidth. Inter-symbol interference is introduced in a controlled manner so that it can be subtracted out to recover the original values. Duobinary data can be generated by sending (Non Return to Zero) NRZ data through a 'delay and add' filter. This filter has a *Z-*transform of the form *H*(*z*) = 1 + *z*⁻¹ and corresponds to a low pass filter.

EP-A-0339727 describes a way of using the limited bandwidth of the backplane channel advantageously to transform the NRZ signal into a duobinary signal. The roll-off response of a backplane is also a low pass filter but one that is too steep. The idea is to add, either before or after the backplane a filter which when combined with the backplane, will have the same shape as the 'delay and add' filter of the form *H*(*z*) = 1 + *z*⁻¹ to help shape the data waveform which is to be sent to the receiver and produce the duobinary signal. This filter emphasizes the higher frequency components, and provides flattening of the group-delay response across the band.

However, a high speed duobinary to binary data converter is required so as not to lose the increased speed. Such a converter has been proposed in EP-A-0339727 based on EP-B-0551858. While the proposed duobinary to binary converter has been successful for data rates of the order of 10-20 Gb/s with error rates <10⁻¹⁵, even higher data rates of 40 to 80 Gb/s should now be achievable with the same method using modern chip technologies. To reach these new higher data rates, the differential limiting amplifiers need to operate with bandwidths and gains which can be up to two times those currently employed. Typically, an increase in gain is usually obtained at the expense of a loss in bandwidth.

### Summary of the disclosure

It is an object of the present disclosure to provide a method for signal processing which provides both an increase in gain and an increase in bandwidth without the corresponding tradeoff.

In accordance with one aspect of the present disclosure, there is provided a method of converting a multi-level signal comprising a plurality of levels of modulation into an output signal, the method comprising the steps of:
a) defining a demodulation path for each level of modulation;
b) providing the multi-level signal for each demodulation path;
c) providing at least one amplifier in each demodulation path for amplifying each level of modulation; and
d) connecting each amplified level of modulation to at least one logic gate to provide the output signal;
   characterised in that step c) comprises the steps of:
   c1) level shifting each level of modulation prior to amplification; and
   c2) amplifying each shifted level of modulation to optimise both bandwidth and gain for the output signal.

By having level shifting and then amplification, the speed limitation of conventional differential limiting amplifier circuits no longer becomes an issue when demodulating a multi-level signal.

Moreover, each amplifier requires less gain, which enables a higher analog bandwidth for the amplifier circuits. This higher bandwidth of the amplifier circuits allows for an increased data rate.

In one embodiment of the disclosure, a first level shifting amplifier is used to perform steps c1) and c2).

In another embodiment, steps c1) and c2) are repeated at least once using at least one further level shifting amplifier. This has the advantage of being able to optimise the gain and the available bandwidth.

The method further comprises the step of tuning each level shifting amplifier in accordance with a reference signal to adjust the amount of level shifting. This has the advantage that the amount of offset introduced into each modulation path can be adjusted to provide better distinction of the levels of the output signal.

In accordance with another aspect of the present disclosure, there is provided a converter for converting a multi-level signal comprising a plurality of levels of modulation to an output signal, the converter comprising:
a demodulation path for each level of modulation;
means for providing the multi-level signal for each demodulation path;
at least one amplifier within each demodulation path for amplifying the multi-level signal; and
at least one logic gate connected to each demodulation path for providing the output signal;
characterised in that each demodulation path comprises a cascade of amplifiers, at least one amplifier providing level shifting and amplification of the level shifted signal for optimising both bandwidth and gain for the output signal.

By having at least one amplifier which provides level shifting and subsequent amplification, the output from each demodulation path has increased gain and an increased bandwidth without having to suffer the trade-off as is usual with prior art systems.

In one embodiment, each level shifting amplifier shifts the multi-level signal to a zero level which relates to an eye opening corresponding to a level of the demodulation path.

In another embodiment, each level shifting amplifier shifts the multi-level signal so that only a part of the signal is available for amplification. By shifting the signal this way, only the relevant part of the signal is made available for amplification. In the specific embodiment of a duobinary signal having two demodulation paths, for example, an upper path and a lower path, the signals in each of the upper and lower paths can be shifted so that only one part of each signal is available for amplification.

In a further embodiment, each level shifting amplifier compresses a part of the signal not available for amplification. This reduces the processing power required as parts of the signal not to be amplified in each demodulation path are compressed.

In a preferred embodiment, each level shifting amplifier has a gain greater than 1.

In another preferred embodiment, each level shifting amplifier is tunable in accordance with a reference signal. By tuning each level shifting amplifier, it is possible to adjust the amount by which the signal is shifted in each demodulation path and therefore the part of the signal which is amplified for output.

### Brief description of the drawings

For a better understanding of the present disclosure, reference will now be made, by way of example, to the accompanying drawings in which:-
Figure 1 shows a circuit used to convert a duobinary data stream to a NRZ binary data stream according to prior art;
Figure 2 shows the waveform of the data stream in different locations of the circuit shown in Figure 1;
Figure 3 shows the duobinary to binary converter according to one embodiment of the present disclosure;
Figure 4 shows the different waveforms of the data stream for a duobinary signal in different locations of the circuit shown in Figure 3; and
Figure 5 shows one embodiment of the amplifier with level shifting and amplification;
Figure 6 shows a PAM-4 to binary converter according to the present disclosure;
Figure 7 shows the different waveforms of the data stream for a PAM-4 signal in different locations of the circuit shown in Figure 6;
Figure 8 shows an example implementation of a logic circuit shown in Figure 6.

### Description of the disclosure

The present disclosure will be described with respect to particular embodiments and with reference to certain drawings but the disclosure is not limited thereto. The drawings described are only schematic and are non-limiting. In the drawings, the size of some of the elements may be exaggerated and not drawn on scale for illustrative purposes.

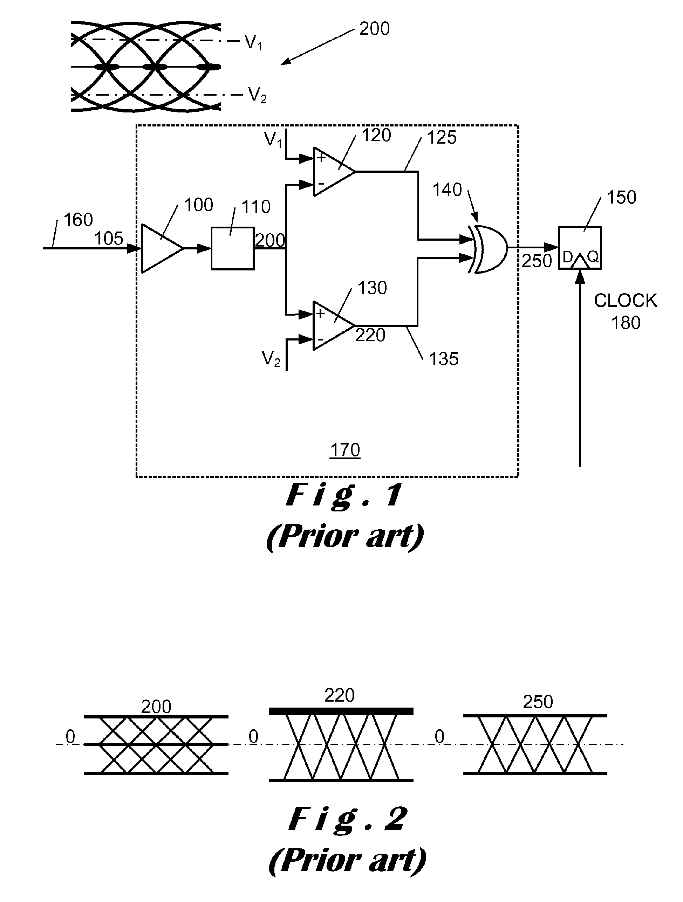

Figure 1 illustrates a circuit which converts a duobinary signal 105 transmitted through a channel 160 to a receiver 170 to generate a binary NRZ signal 250 as described in US-B-7508882. The receiver 170 comprises a wideband amplifier 100, a wideband splitter 110, first and second comparators 120 and 130, and a logic asynchronous XOR gate 140 which outputs a decoded NRZ signal 250 and feeds it afterwards to a D-FlipFlop 150 with a clock 180. The resulting decoded synchronized NRZ data stream 250 is further processed within the chip. An input duobinary signal, after amplification by the wide band amplifier 100, is shown in an eye diagram 200 in the top of Figure 1 where only one line has been represented for the purpose of clarity.

The comparators 120, 130 may be implemented with differential amplifiers.

The upper and lower threshold voltages *V*₁ and *V*₂ respectively correspond to the upper and lower eye crossings, shown in the eye diagram 200.

The duobinary signal is divided into two identical signals 200 by the wideband splitter 110. A first signal follows an upper path 125 and is applied to an inverting input of the first comparator 120. A second signal follows a lower path 135 and is applied to a non-inverting input of the second comparator 130. Threshold voltage *V*₁ is applied to the non-inverting input of the first comparator 120 whereas threshold voltage *V*₂ is applied to the inverting input of the second comparator 130.

Figure 2 illustrates waveforms of the duobinary signal in different locations of the circuit shown in Figure 1. A waveform for the lower path 135 is illustrated. It will be appreciated that the waveform (not shown) for the upper path 125 is effectively the same as that for the lower path but inverted. Waveform 200 corresponds to the duobinary signal after the wideband splitter 110. The signal is then applied to the non-inverting input of the second comparator 130. Waveform 220 corresponds to the signal at the output of the second comparator 130. All signal values higher than the threshold level *V*₂ are set to 1, whereas the signal values below the threshold level *V*₂ are set to -1. Since there are more signal values having the value of 1 compared to those having the value of -1, the upper line is drawn thicker. Similarly, for the other threshold level (in the upper path), the lower line would be thicker as there are more signal values having the value of -1 than those having the value of 1. [The values 1 and -1 correspond to the respective digital high and low inputs of the logic gate.] Finally, waveform 250 corresponds to the NRZ signal obtained after the XOR gate 140.

The main drawback of this implementation concerns the transmission of high speed data, greater than about 25 Gb/s. For high data rates, the requirements on the bandwidth and the gain are more stringent. As a trade-off between gain and bandwidth needs to be done for optimisation, a solution to increase the bandwidth without reducing the gain comprises using a cascade of differential amplifiers as described in US-A-4441121. A cascade of amplifiers comprises at least 2 amplifiers mounted in series. In this manner, each differential limiting amplifier requires less gain, which enables a higher analog bandwidth for the amplifier circuit. Depending on the total gain required, a cascade of 2 or more differential amplifiers can be implemented.

It is important to bear in mind that an offset is introduced within an amplifier due to the unbalanced DC component of a signal. When a signal goes through a differential amplifier, the non-zero DC component of the signal introduces an offset which shifts the signal up or down to counteract the DC component in the differential signal.

A solution to this problem is to use a cascade of amplifiers with level shifting correction in each amplifier to compensate for the offset introduced by the amplifier, but also to shift the 0 signal level to the most suitable position. The level shifting stage in the amplifier shall be such that the 0 level of the duobinary signal after level shifting correction corresponds to the lower eye crossing or the *V*₁ threshold for the upper path and to the higher eye crossing or the *V*₂ threshold for the lower path. The level shifting can be set manually or automatically by a feedback loop. The thresholds in the amplifier have now a new function within the amplifier: they define the level shifting and not the differential amplification.

The design of such amplifiers is therefore different from the differential amplifiers used in the prior art. In one embodiment, the controlled and tunable level shifting is implemented inside the differential amplifier. The term "differential limiting amplifier with level shifting" will be referred to hereinafter as "level shifting amplifier".

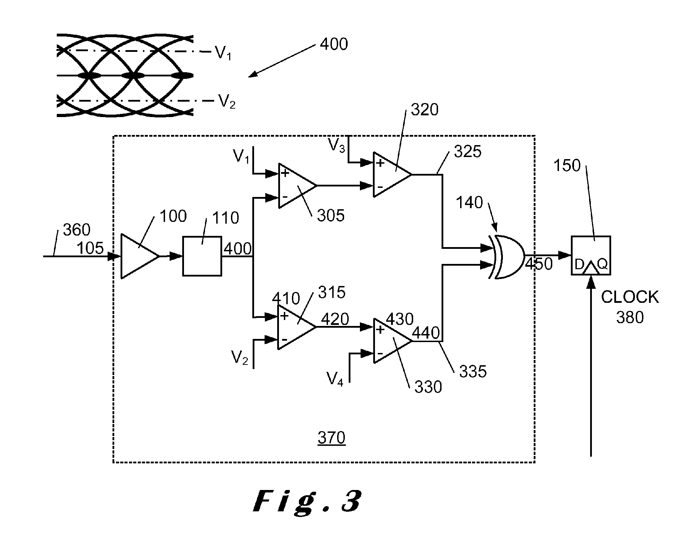

Referring now to Figure 3, one embodiment of the present disclosure is shown for a duobinary signal in which an upper path 325 and a lower path 335 respectively comprise a cascade of two level shifting amplifiers. The first two level shifting amplifiers in the corresponding paths are now referenced as 305 and 315 respectively, and replace the comparators 120, 130 of the circuit shown in Figure 1. As before, a duobinary signal 105 is transmitted through a channel 360 to a receiver 370 to generate a binary NRZ signal 450.

The receiver 370 comprises a wideband amplifier 100, a wideband splitter 110, and a logic asynchronous XOR gate 140 as described with reference to Figure 1. The logic asynchronous XOR gate 140 decodes the NRZ signal 450 and feeds it afterwards to the D-FlipFlop 150 with a clock 180. In this case, apart from the replacement of comparators 120, 130 with level shifting amplifiers 305 and 315, there is an addition of at least one further level shifting amplifier 320, 330 in the upper and lower paths respectively.

The output of the level shifting amplifier 305 is now the inverting input of the level shifting amplifier 320 and the output of the level shifting amplifier 315 is now the non-inverting input of the level shifting amplifier 330. The new voltage thresholds *V*₃ and *V*₄ are now respectively the non-inverting input of the level shifting amplifier 320 and the inverting input of the level shifting amplifier 330, which also corresponds to the upper and lower eye crossings of the related eye diagrams.

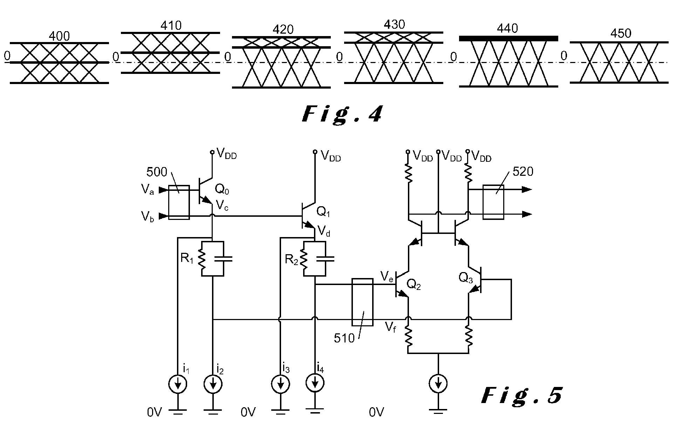

Figure 4 illustrates the waveforms of the duobinary signal in the lower path 335 of the circuit shown in Figure 3 taken at six different locations within that path. Waveform 400 corresponds to the duobinary signal after the wideband splitter but before the first amplification in the level shifting amplifier 315. Waveform 410 is the duobinary signal after level shifting correction such that its 0 level corresponds to the lower eye crossing and to the *V*₂ level. Waveform 420 illustrates the duobinary signal after amplification in the level shifting amplifier 315. The response of an amplifier is only linear in a small range around the zero level. For higher voltage values, an amplifier will saturate to a value of *Vₛₐₜ* such that no further amplification (gain of zero) is obtained after this value has been reached. This explains the shape of waveform 420, where the upper eye is flattened due to the gain loss around the saturation value. This waveform does not correspond to the desired shape. However, the next stage will not only allow for a gain and bandwidth increase but the additional stage will also improve the shape of the signal. Waveform 430 is obtained after the level shift correction where the 0 level of the signal now corresponds to the lower eye crossing and to the *V*₄ level. After the second amplification, waveform 440 is obtained. This waveform corresponds to that of the desired NRZ signal containing a fully amplified lower part of the eye diagram and where the upper part of the eye diagram is shown as a solid line. Waveform 450 illustrates the signal after it has been combined in the XOR gate 140.

It will readily be appreciated that the waveforms for the upper path 325 will be inverted so that the shifting is performed downwards instead of upwards and that the lower part of the eye diagram is the equivalent of a solid line.

Figure 5 shows an embodiment of a differential implementation of an amplifier with a tunable level shifting which can be used in the circuit shown in Figure 3 for the level shifting amplifiers 305, 315, 320 and 330. The input signal is applied to the input terminals of the amplifier indicated by region 500. The level shifted input signal is observed at the intermediate terminals indicated by region 510, and the amplification is observed at the output terminals indicated by region 520. The amplifier as shown in Figure 5 thus comprises two stages, a first stage that level shifts the input signal and a second stage that amplifies the level shifted signal.

The first stage of the amplifier is implemented using two transistors *Q*₀ and *Q*₁ in an emitter-follower configuration. The use of emitter followers has two main benefits. Firstly, they provide a low output impedance, and as a result allow for a higher bandwidth when driving the capacitive input of the cascaded second stage comprising transistors *Q*₂ and *Q*₃. Secondly, the voltage relationship between base and emitter (given a constant emitter current) of the emitter-follower transistors is fixed. This results in an equal DC voltage at the emitters of transistors *Q*₀ and *Q*₁. In order to introduce a shift in DC voltage, and hence in a threshold voltage, a series resistor *R*₁, *R*₂ is added between the output of the respective emitter-follower *Q*₀*, Q*₁ and the respective input of the second stage. The biasing current of each emitter-follower transistor is split into two parts, one directly connected to its emitter and one connected to through the series resistor. By changing the ratio of these two current sources (e.g. the ratio between *i*₁ and *i*₂, and the ratio between *i*₃ and *i*₄), the amount of current flowing through the respective resistor and hence the DC level at the respective input of the next stage can be controlled. By varying the DC voltage of the positive and negative input of the amplifier, i.e. by varying the ratio between the *i*₁ and *i*₃, the resulting threshold voltage can be adjusted.

An embodiment can be realized with the following values. The voltage supply being *V_{DD}*=2.5V, input voltages *Vₐ*=*V_{b}*=2.4V, which results in a differential offset of 0V. With the following values for the resistors *R*₁=*R*₂=100Ω, and the current sources *i*₁=1mA, *i*₂=2mA, *i*₃=2mA, *i*₄=1mA, the intermediate voltages have the following values *V_{c}* = *V_{d}*=1.5V and *Vₑ*=1.4V and *V_{f}*=1.3V. The level shifting stage 510 has an offset of *Vₑ - V_{f}* =100mV.

The upper or lower thresholds of the level shifting amplifier which depend on the eye crossing in the eye diagram can be set manually by looking at the eye diagrams or automatically using a feed-back loop. Such an automated method is described in US-B-8416840 where the reference voltages are predetermined by incorporating a reference free comparator and a servo controller that dynamically optimizes the output data eye.

The level shifting amplifier can also be realized using a similar circuit, called slicing threshold adjustment circuit, and is described in "A 1-tap 40-Gbps look-ahead decision feedback equalizer in 0.18 µm SiGe BiCMOS technology" by Garg, et al., "Compound Semiconductor Integrated Circuit Symposium, 2005. CSIC '05. IEEE, 2005.

It will be clear to a person skilled in the art that the implementation is suitable not only to electrical but also to optical signal receivers. In the latter case, the duobinary or multi-level signal can be modulated in amplitude or phase of the optical carrier signal. Therefore, the use of a direct detection or coherent optical receiver augmented by a local carrier is envisaged. This results in linear optical signal detection with 3 intensity levels after the receiver photodiode suitable for reception using the method according to the present disclosure.

This embodiment illustrates the case of a duobinary partial response but the method is not limited to a three-level signal. Any signal modulated according to a multi-level modulation format can also be received according to the scheme of the present disclosure when the receiver implements multiple detection thresholds (in the differential limiting amplifiers), multiple level shifting stages in the corresponding differential limiting amplifiers and multiple-input logic operations to determine the symbol value. A multi-level signal is a signal having a period T and comprising n signal levels, n being equal to or greater than 3. Examples of multi-level signals include duobinary, polybinary, PAM-4, PAM-8 signals etc. as described above. The number of circuit (i.e. demodulation) paths depends on the number of levels of the multi-level signal. For a n-level signal, there are n-1 circuit paths. Hence, for a PAM-4 signal (i.e. n=4) there are 3 circuit paths.

Moreover, whilst a single XOR gate is shown for producing the output signal from the upper and the lower paths, it will be appreciated that other logic circuits can be used, either alone or in combination with other logic circuits. For example, where multiple paths are required, a series of logic circuits may be required to provide a single output signal.

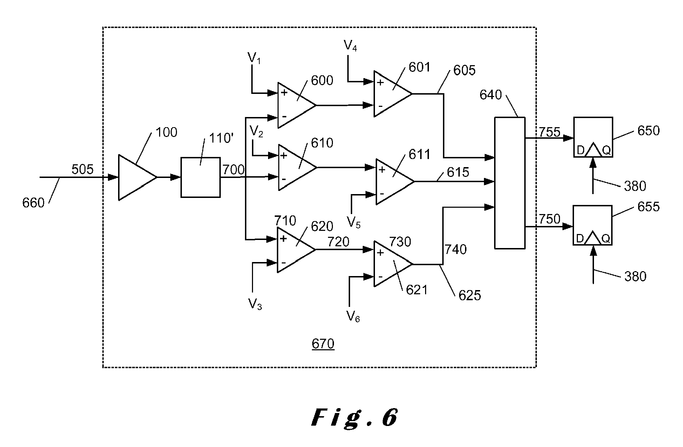

Figure 6 shows one embodiment of the circuit according to the present disclosure for demodulating a PAM-4 signal (i.e. n=4) into a binary signal. The circuit comprises three demodulation paths: an upper path 605, a middle path 615 and a lower path 625, wherein each demodulation path comprises at least two level shifting amplifiers connected in cascade. A PAM-4 signal 505 is transmitted through a channel 660 to a receiver 670. The receiver 670 comprises a wideband amplifier 100, a wideband splitter 110', and a logic circuit 640. The logic circuit 640 outputs two decoded NRZ signals 750 and 755. The receiver 670 thus generates two binary NRZ signals 750 and 755, which are subsequently fed to respective D-FlipFlops 650 and 655 clocked with a clock signal 380.

The received multi-level signal, i.e. the PAM-4 signal, is split into three identical signals 700 by the wideband splitter 110'. The three identical signals are respectively fed to each of the upper, middle and lower paths 605, 615 and 625 of the circuit 670. In a similar way to the embodiment of Figure 3, each demodulation path comprises a series of two level shifting amplifiers. The upper path 605 comprises level shifting amplifiers 600 and 601, the middle path comprises level shifting amplifiers 610 and 611 and the lower path 625 comprises the level shifting amplifiers 620 and 621. As shown, the output of the level shifting amplifier 600 is the inverting input of the level shifting amplifier 601; the output of the level shifting amplifier 610 is the non-inverting input of the level shifting amplifier 611; and the output of the level shifting amplifier 620 is the non-inverting input of the level shifting amplifier 621.

The voltage thresholds *V₁, V*₂ and *V*₃ are respectively applied to the non-inverting input of the level shifting amplifier 600, the non-inverting input of the level shifting amplifier 610, and the inverting input of the level shifting amplifier 620 as shown. Each of the voltage thresholds *V*₁*, V*₂ and *V*₃ corresponds to respective ones of the upper, middle and the lower eye crossings of the related eye diagrams. The voltage thresholds *V*₄, *V*₅ and *V*₆ are respectively applied to the non-inverting input of the level shifting amplifier 601, the inverting input of the level shifting amplifier 611, and the inverting input of the level shifting amplifier 621 as shown. Each of the voltage thresholds *V*₄, *V*₅ and *V*₆, corresponds to respective ones of the upper, middle and lower eye crossings of the related eye diagrams. The voltage *V*₂ and *V*₅ are set to the middle of the eye diagram, for example at 0V.

Similar to above, an amplifier with a tunable level shifting shown in Figure 5 can be used for the level shifting amplifiers 600, 601, 610, 611, 620 and 621.

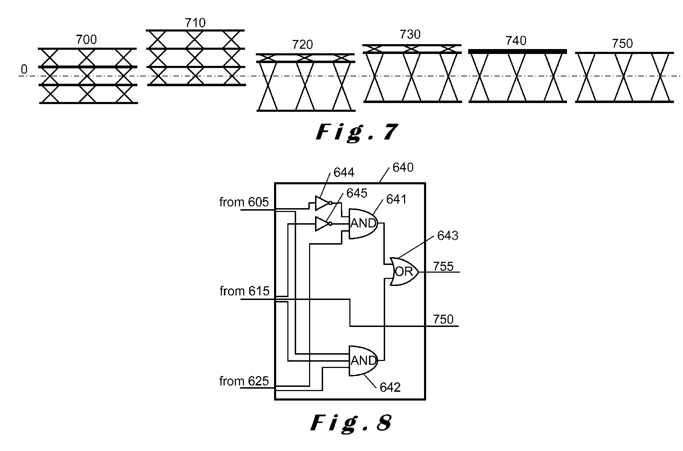

Figure 7 illustrates the waveforms of the PAM-4 signal in the lower path 625 of the circuit shown in Figure 6 taken at six different locations within that path. Waveform 700 corresponds to the PAM-4 signal after the wideband splitter 110' but before the first amplification in the level shifting amplifier 620. Waveform 710 is the PAM-4 signal after level shifting correction such that its 0 level corresponds to the lower eye crossing and to the *V*₃ level. Waveform 720 illustrates the PAM-4 signal after amplification in the level shifting amplifier 620. Similar to embodiment of Figure 3, the shape of waveform 720 around the middle eye is flattened due to the gain loss around the saturation value and the upper eye is fully flattened to a solid line as the saturation level is reached. This waveform does not yet correspond to the desired shape. However, the next stage will not only allow for a gain and bandwidth increase but it will also improve the shape of the signal.

Waveform 730 is obtained after the level shift correction where the 0 level of the signal now corresponds to the lower eye crossing and to the *V*₆ level. After the second amplification, waveform 740 is obtained. This waveform corresponds to that of the desired NRZ signal containing a fully amplified lower eye of the eye diagram and where the rest of the eye diagram, both the upper and the middle eye of the eye diagram, are now fully flattened to a solid line. Waveform 750 illustrates the decoded NRZ signal after it has been combined in the logic circuit 640.

It will readily be appreciated that the waveforms for the upper path 605 will be inverted so that the shifting is performed downwards instead of upwards and that the lower part of the eye diagram is the equivalent of a solid line. The waveforms for the middle path 615 will be centered around the 0 level of the middle eye as the signal is shifted to the eye crossing of the middle eye of the eye diagram. The middle eye is thus fully amplified and both the lower and the upper parts of the eye diagram are the equivalent of solid lines. As a result, the circuit generates three demodulated signals.

Figure 8 shows an example implementation of the logic circuit 640 that decodes to resulting three fully amplified eyes in the demodulation paths 605, 615, 625 into two NRZ signals 750, 755. The signal at the output of the second demodulation path 615, i.e. the fully amplified middle eye, is directly fed to the first output of the logic circuit 640 to generate the first decoded NRZ signal 750, and the signals at the output of the first and third demodulation paths 605, 625 are logically combined to create the second decoded NRZ signal 755.

The logic circuit 640 comprises two AND logic gates 641 and 642, each arranged to receive, at its input, the demodulated NRZ signals from the three demodulation paths 605, 615, 625. The first logic gate 641 receives the fully amplified lower eye signal directly from demodulation path 625, and, the upper and middle fully amplified eyes, from demodulation paths 605 and 615, through respective inverter logic gates 644 and 645. The second logic gate 642 receives the three fully amplified eyes directly from the demodulation paths 605, 615, 625. The output of the AND logic gates 641 and 642 are then fed to an OR logic gate 643 to create the second decoded NRZ signal 755.

It will readily be appreciated that the implementation of the logic circuit 640 is defined by the type of the received multi-level signal, e.g. duobinary, polybinary, PAM-4, PAM-8 etc. For example, for a duobinary signal, the logic circuit is implemented as a logic XOR gate 450 as shown in Figure 3, while for a PAM-4 signal the example implementation of a logic circuit as shown in Figure 8 may be used. However, it will readily be appreciated that other implementation for the logic circuit 640 can be used as well.

Although the present disclosure has been described with reference to certain embodiments, it will readily be appreciated that other embodiments are possible.

## Claims

1. A method of converting a multi-level modulated signal (105; 605) comprising a plurality of levels of signal modulation into at least one output signal (450; 750, 755), the method comprising the steps of:
a) defining a demodulation path (325, 335; 605, 615, 625) for each level of signal modulation;
b) providing the multi-level signal (400; 700) for each demodulation path (325, 335; 605, 615, 625);
c) providing at least one amplifier (305, 315, 320, 330; 600, 601, 610, 611, 620, 621) in each demodulation path (325, 335; 605, 615, 625) for amplifying each level of signal modulation; and
d) connecting each amplified level of signal modulation in each demodulation path (325, 335; 605, 615, 625) to at least one logic gate (140; 641, 642, 643) to provide the output signal (450; 750, 755);
**characterised in that** step c) comprises the steps of:
c1) level shifting each level of signal modulation prior to amplification; and
c2) amplifying each shifted level of signal modulation to optimise both bandwidth and gain for the output signal (450; 750, 755).

2. A method according to claim 1, further comprising the step of using a first level shifting amplifier (305, 315; 600, 610, 620) to perform steps c1) and c2).

3. A method according to claim 1 or 2, further comprising the step of repeating steps c1) and c2) at least once using at least one further level shifting amplifier (320, 330; 601, 611, 621).

4. A method according to claim 2 or 3, further comprising the step of tuning each level shifting amplifier (305, 315, 320, 330; 600, 601, 610, 611, 620, 621) in accordance with a reference signal (V₁, V₂, V₃, V₄; V₅, V₆) to adjust the amount of level shifting.

5. A converter (370; 670) for converting a multi-level signal (105; 605) comprising a plurality of levels of signal modulation to at least one output signal (450; 750, 755), the converter comprising:-
a demodulation path (325, 335; 605, 615, 625) for each level of signal modulation;
means (110; 110') for providing the multi-level signal for each demodulation path (325, 335; 605, 615, 625);
at least one amplifier (305, 315, 320, 330; 600, 601, 610, 611, 620, 621) within each demodulation path for amplifying each level of the multi-level signal; and
at least one logic gate (140; 641, 642, 643) connected to each demodulation path for providing said at least one output signal (450; 750, 755);
**characterised in that** each demodulation path comprises a cascade of amplifiers (305, 315, 320, 330; 600, 601, 610, 611, 620, 621), at least one amplifier providing level shifting and amplification of the level shifted signal for optimising both bandwidth and gain for the output signal.

6. A converter according to claim 5, wherein each level shifting amplifier (305, 315, 320, 330; 600, 601, 610, 611, 620, 621) shifts the multi-level signal to a zero level which relates to an eye opening corresponding to a signal level of the demodulation path.

7. A converter according to claim 5 or 6, wherein each level shifting amplifier (305, 315, 320, 330; 600, 601, 610, 611, 620, 621) shifts the multi-level signal so that only a part of the signal is available for amplification.

8. A converter according to claim 7, wherein each level shifting amplifier (305, 315, 320, 330; 600, 601, 610, 611, 620, 621) compresses a part of the signal not available for amplification.

9. A converter according to any one of claims 5 to 8, wherein each level shifting amplifier (305, 315, 320, 330; 600, 601, 610, 611, 620, 621) has a gain greater than 1.

10. A converter according to any one of claims 5 to 9, wherein each level shifting amplifier (305, 315, 320, 330; 600, 601, 610, 611, 620, 621) is tunable in accordance with a reference signal (V₁, V₂, V₃, V_{4;}V₅, V₆).
